# EUROPEAN PATENT APPLICATION

(11) **EP 4 779 689 A1**
(43) Date of publication of application: **22.07.2026**
(21) Application number: 24869781.5
(22) Date of filing: 27.05.2024
(51) Int. Cl.: H01L 23/522, H01L 23/49, H01L 21/60

(54) **ELECTRONIC ASSEMBLY, ELECTRONIC DEVICE, AND MANUFACTURING METHOD FOR ELECTRONIC ASSEMBLY**

(30) Priority: 28.09.2023 CN 202311284163
(71) Applicant: HUAWEI TECHNOLOGIES CO., LTD., Shenzhen 518129 (CN)
(72) Inventor: ZONG, Fei, Shenzhen, Guangdong 518129 (CN); ZHANG, Shengli, Shenzhen, Guangdong 518129 (CN)
(74) Representative: Maiwald GmbH
(86) International application number: PCT/CN2024/095565
(87) International publication number: WO 2025/066216

(57) **Abstract**

This application provides an electronic assembly, an electronic device, and a preparation method for an electronic assembly. The electronic device includes a first component, a second component, and at least two wires. The first component includes a first pad, and the second component includes a second pad. The at least two wires include a first wire and a second wire, the first wire is soldered between the first pad and the second pad, and the second wire is also soldered between the first pad and the second pad. The first wire and the second wire are connected in parallel, so that parasitic inductance caused by the wires is reduced, an operating bandwidth of the electronic assembly is improved, a signal transmission rate of the electronic assembly is improved, and the like. In this way, the electronic assembly has good performance. A solder joint between the first wire and the first pad and a solder joint between the second wire and the first pad are stacked. In this case, a size of the first pad may be designed to be small. This helps increase a density of the pad of the first component and increase a density of a signal transmission wire of the first component.

## Description

### CROSS-REFERENCE TO RELATED APPLICATIONS

This application claims priority to Chinese Patent Application No. 202311284163.2, filed with the China National Intellectual Property Administration on September 28, 2023 and entitled "ELECTRONIC ASSEMBLY, ELECTRONIC DEVICE, AND PREPARATION METHOD FOR ELECTRONIC ASSEMBLY", which is incorporated herein by reference in its entirety.

### TECHNICAL FIELD

This application relates to the field of electronic device technologies, and in particular, to an electronic assembly, an electronic device, and a preparation method for an electronic assembly.

### BACKGROUND

In the semiconductor field, many chips are packaged with substrates to form chip modules, and then are used as a module in electronic devices. In a chip packaging process, a wire bonding (wire bonding) process is used to implement a connection between chips and a connection between chips and substrates. Specifically, wire bonding is a process in the chip packaging industry and is a technology in which a thin metal wire is usually used to connect chips or connect a chip and a substrate, to transmit a signal via the metal wire.

As communication rates increase, high-frequency signals are prone to generating parasitic inductance at wire positions, which affects quality of the high-frequency signals. In the field of optoelectronic packaging, parasitic inductance reduces operating bandwidths of driver chips and semiconductor lasers, which affects performance of optoelectronic devices.

To resolve the problem of parasitic inductance, conventional solutions include increasing a wire diameter, reducing a wire length, and connecting a plurality of wires in parallel. However, these solutions also bring restrictions. For example, increasing the wire diameter leads to an increase in wire bonding process parameters, and also an increase in requirements on materials of pads and substrate layers. In addition, connecting the plurality of wires in parallel inevitably causes an increase in required wire pad areas, resulting in an increase in overall sizes of the devices, which does not meet requirements of miniaturization.

### SUMMARY

This application provides an electronic assembly, an electronic device, and a preparation method for an electronic assembly, to reduce parasitic inductance caused by a wire and improve an operating bandwidth of the electronic assembly, reduce a size of a pad, increase a density of a pad of a first component, and increase a quantity of signals transmitted by the first component.

According to a first aspect, this application provides an electronic assembly. The electronic device includes a first component, a second component, and at least two wires, where the first component includes a first pad, and the second component includes a second pad. The wires are soldered between the first pad and the second pad, and are configured to implement an electrical connection between the first component and the second component. Specifically, the at least two wires include a first wire and a second wire. The first wire is soldered between the first pad and the second pad, the second wire is also soldered between the first pad and the second pad, and the first wire and the second wire are connected in parallel, so that parasitic inductance caused by the wires are reduced, an operating bandwidth of the electronic assembly is improved, a signal transmission rate of the electronic assembly is improved, and the like. In this way, the electronic assembly has good performance. In this solution, a diameter of the wire may be designed to be small, thereby reducing a risk of damage to the first pad. A solder joint between the first wire and the first pad and a solder joint between the second wire and the first pad are stacked. In this solution, a size of the first pad may be designed to be small. This helps increase a density of the pad of the first component, increase a quantity of signals transmitted by the first component, and increase a density of a signal transmission wire of the first component.

In a further technical solution, a solder joint between the first wire and the second pad and a solder joint between the second wire and the second pad are stacked. In this solution, a size of the second pad may be designed to be small, and a density of the pad disposed on the second component may be high. This helps increase a quantity of signals transmitted by the second component, and increase a density of a signal transmission wire of the second component.

In another technical solution, the solder joint between the first wire and the second pad and a solder joint between the second wire and the second pad are arranged side by side on a surface of the second pad. Solder joints between the at least two wires and the second pad are arranged in a row on the surface of the second pad. This solution helps simplify a wire bonding process of the first component and the second component.

Specifically, the wire includes a wire body and a solder ball, the solder ball and the wire body are of an integrated structure, the solder ball is located at one end of the wire body, one end that is of the wire and at which there is the solder ball is a first bonding point, and the other end of the wire is a second bonding point. Using a metal wire for wire bonding helps improve bonding strength.

When the first component and the second component are soldered by using wires that have solder balls and wire bodies, the wires may be arranged in a plurality of manners. For example, in a specific technical solution, the first bonding point of the first wire is soldered to the first pad, and the first bonding point of the second wire is soldered to the first pad. In two adjacent wires, a first bonding point of one wire is soldered to the first pad, and a first bonding point of the other wire is soldered to the first pad.

In another specific technical solution, in two adjacent wires, a first bonding point of one wire is soldered to the first pad, and a second bonding point of the wire is soldered to the second pad; and a second bonding point of the other wire is soldered to the first pad, and a first bonding point of the other wire is soldered to the second pad. The first bonding points of the plurality of wires are stacked on the first pad, and the second bonding points of the plurality of wires are soldered to the second pad.

To improve reliability of a connection between the first component and the second component, when the second bonding point is directly soldered to the first pad, there is a solder bump between the second bonding point and the first pad; or when the second bonding point is directly soldered to the second pad, there is a solder bump between the second bonding point and the second pad. In conclusion, a second bonding point of a wire is an end that is of a wire body and that is away from a solder ball, and has a small size is. Therefore, directly soldering the second bonding point to a pad easily causes damage to the pad. In the technical solutions of this application, the second bonding point is soldered to the pad via the solder bump, which helps improve reliability of soldering between the second bonding point of the wire and the pad.

When the wire is specifically formed, the wire body is tilted toward the first pad within a preset length on a side that is of the wire body and that is connected to the solder ball, so that the wire is relatively flat above the solder ball, thereby facilitating soldering and stacking another wire above the first bonding point of the wire, and preventing the wire from being tilted. In this way, reliability of soldering between adjacent wires is improved, and it is less likely to cause short circuits during wire stacking.

In addition, an arc height of the wire body of the wire is less than or equal to 50 µm. The wire has a low arc height and small parasitic inductance. This also helps improve an operating bandwidth of the electronic assembly, improves a signal transmission rate of the electronic assembly, and the like. In this way, the electronic assembly has good performance. In addition, in this solution, the wire is also relatively flat near the second bonding point. This facilitates soldering and stacking another wire above the second bonding point of the wire, and prevents the wire from being tilted. In this way, reliability of soldering between adjacent wires is improved, and it is less likely to cause short circuits during wire stacking.

In an optional technical solution, there are a plurality of types of the first component and the second component in the electronic assembly. In a technical solution, the first component is a photodetector, and the second component is a trans-impedance amplifier; the first component is a driver, and the second component is a modulator; the first component is a trans-impedance amplifier, and the second component is an optical chip; or the first component is a chip, and the second component is a substrate.

According to a second aspect, this application provides an electronic device. The electronic device includes a circuit board, an electronic component, and the electronic assembly provided in the first aspect. The electronic component is electrically connected to the electronic assembly, and the electronic component and the electronic assembly are disposed on the circuit board. The electronic assembly has a wide bandwidth and good performance. Therefore, the electronic device also has high performance.

According to a third aspect, this application further provides a preparation method for an electronic device. The electronic assembly prepared by using the preparation method includes a first component, a second component, a first wire, and a second wire, the first component includes a first pad, and the second component includes a second pad. The preparation method specifically includes:
soldering one end of the first wire to the first pad to form a first solder joint, and soldering the other end of the first wire to the second pad to form a second solder joint; soldering one end of the second wire to the first solder joint, and soldering the other end of the second wire to the second solder joint; and connecting the first wire and the second wire in parallel. According to the preparation method, parasitic inductance caused by the wires is reduced, an operating bandwidth of the electronic assembly is improved, a signal transmission rate of the electronic assembly is improved, and the like. In this way, the electronic assembly has good performance. In this solution, a diameter of the wire may be designed to be small, thereby reducing a risk of damage to the first pad. There is one solder joint between one wire and the first pad, and solder joints of at least two wires are stacked. In this solution, a size of the first pad may be designed to be small. This helps increase a density of the pad of the first component, increase a quantity of signals transmitted by the first component, and increase a density of a signal transmission wire of the first component.

According to a fourth aspect, this application further provides a preparation method for an electronic assembly. The electronic assembly prepared by using the preparation method includes a first component, a second component, a first wire, and a second wire, the first component includes a first pad, and the second component includes a second pad. The preparation method specifically includes:
soldering one end of the first wire to the first pad to form a first solder joint, and soldering the other end of the first wire to the second pad to form a second solder joint; soldering one end of the second wire to the first solder joint, and soldering the other end of the second wire to the second pad to form a third solder joint, where the second solder joint and the third solder joint are arranged side by side on a surface of the second pad; and connecting the first wire and the second wire in parallel. This can reduce difficulty of a bonding process while reducing parasitic inductance of the wire.

### BRIEF DESCRIPTION OF DRAWINGS

FIG. 1 is a diagram of a structure of an electronic assembly according to an embodiment of this application;
FIG. 2 is a diagram of a structure of an electronic device according to an embodiment of this application;
FIG. 3 is a diagram of comparison between eye patterns of electronic devices;
FIG. 4 is a diagram of comparison between working states of electronic assemblies;
FIG. 5 is a diagram of a structure of an electronic assembly according to an embodiment of this application;
FIG. 6 is a top view of a structure of an electronic assembly according to an embodiment of this application;
FIG. 7 is a top view of a structure of an electronic assembly according to an embodiment of this application;
FIG. 8 is a diagram of a structure of an electronic assembly according to an embodiment of this application;
FIG. 9 is a diagram of a structure of a wire according to an embodiment of this application;
FIG. 10 is a diagram of a preparation procedure of an electronic assembly according to an embodiment of this application;
FIG. 11 is a diagram of a preparation procedure of an electronic assembly according to an embodiment of this application;
FIG. 12 is a diagram of a preparation procedure of an electronic assembly according to an embodiment of this application; and
FIG. 13 is a diagram of a preparation procedure of an electronic assembly according to an embodiment of this application.

### Reference numerals:

1: first component; 11: first pad;
2: second component; 21: second pad;
3: wire; 31: wire body;
32: solder ball; 33: first wire;
34: second wire; 4: solder bump;
41: first solder bump; 42: second solder bump;
01: first solder joint; 02: second solder joint; and
03: third solder joint.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include expressions such as "one or more", unless otherwise specified in the context clearly.

Reference to "an embodiment" or "a specific embodiment" or the like described in the specification means that one or more embodiments of this application include a specific feature, structure, or characteristic described with reference to this embodiment. Terms "include", "contain", "have", and their variants all mean "include but are not limited to", unless otherwise specifically emphasized in another manner.

To facilitate understanding of an electronic assembly, an electronic device, and a preparation method for an electronic assembly provided in embodiments of this application, the following first describes application scenarios of the electronic assembly, the electronic device, and the preparation method for the electronic assembly.

The electronic device in embodiments of this application may be an electronic device like a communication device (for example, a router), a computing device (for example, a server), a network device (for example, a switch), or a storage device (for example, a storage array), or may be an electronic device like an optical module, a vehicle-mounted device, or a terminal device. A specific type of the electronic device is not limited in this application. The technical solutions provided in this application may be used for any electronic device that includes an electronic assembly connected by using a wire bonding process.

In a specific embodiment, the electronic device includes a circuit board, an electronic component, and an electronic assembly, the electronic component and the electronic assembly are electrically connected, and the electronic component and the electronic assembly are disposed on the circuit board, to implement functions of the electronic device. The electronic assembly includes a first component and a second component, and the first component and the second component are connected by using the wire bonding process.

There are a plurality of types of selection and combinations of the first component and the second component that are included in the electronic assembly provided in this application. For example, in an embodiment, the first component is a photodetector, the second component is a trans-impedance amplifier, and the photodetector and the trans-impedance amplifier are connected via a wire by using the wire bonding process. Alternatively, in an embodiment, the first component is a driver, the second component is a modulator, and the driver and the modulator are connected via a wire by using the wire bonding process. Alternatively, in an embodiment, the first component is a trans-impedance amplifier, the second component is an electrical chip (ODSP), and the trans-impedance amplifier and the electrical chip are connected via a wire by using the wire bonding process. In the foregoing several specific embodiments, both the first component and the second component are chip components. In another embodiment, the first component is an optical chip, and the second component is a substrate; or the first component is an electrical chip, and the second component is a substrate. In conclusion, the chip and the substrate are connected via a wire by using the wire bonding process. In other words, in embodiments of this application, the first component and the second component may alternatively be respectively the chip and the substrate, and the chip and the substrate may be connected by using the foregoing wire bonding solution.

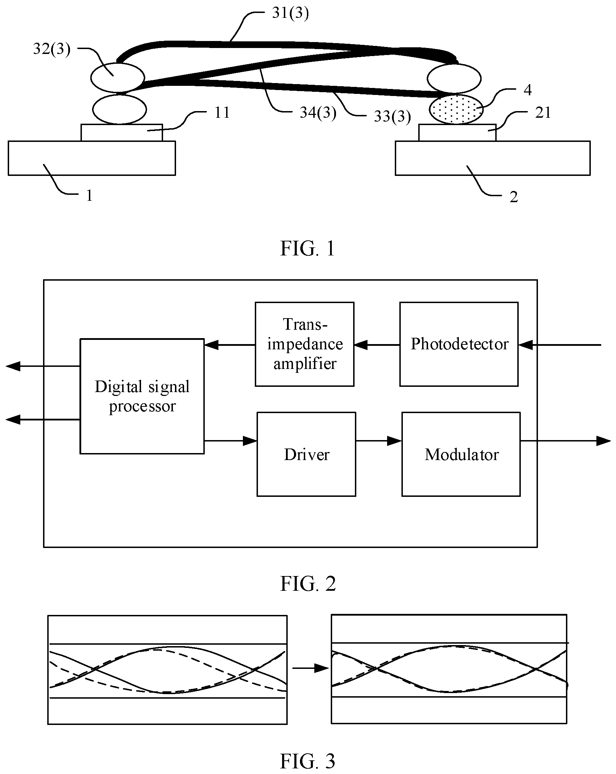

FIG. 1 is a diagram of a structure of an electronic assembly according to an embodiment of this application. As shown in FIG. 1, in an embodiment, the electronic assembly includes a first component 1, a second component 2, and at least two wires 3. The first component 1 includes a first pad 11, and the second component 2 includes a second pad 21. The wires 3 are soldered between the first pad 11 and the second pad 21. Specifically, the wires 3 include a first wire 33 and a second wire 34, the first wire 33 is soldered between the first pad 11 and the second pad 21, and the second wire 34 is also soldered between the first pad 11 and the second pad 21. One end of the wire 3 is soldered to the first pad 11, and the other end of the wire 3 is soldered to the second pad 21, to implement an electrical connection between the first component 1 and the second component 2, for example, to implement signal transmission between the first component 1 and the second component 2. The at least two wires 3 are connected in parallel, so that parasitic inductance caused by the wires 3 is reduced, an operating bandwidth of the electronic assembly is improved, a signal transmission rate of the electronic assembly is improved, and the like. In this way, the electronic assembly has good performance. In this solution, a diameter of the wire 3 may be designed to be small, thereby reducing a risk of damage to the first pad 11. Further, solder joints between the at least two wires 3 and the first pad 11 are sequentially stacked. Specifically, a solder joint between the first wire 33 and the first pad 11 and a solder joint between the second wire 34 and the first pad 11 are stacked. The solder joint between the wire 3 and the first pad 11 is not a solder joint generated by directly soldering the wire 3 to the first pad 11, but is a solder joint at one end that is of the wire 3 and at which the wire 3 is soldered to the first pad 11. In this solution, a size of the first pad 11 may be designed to be small. This helps increase a density of the pad of the first component 1, increase a quantity of signals transmitted by the first component 1, and increase a density of a signal transmission wire of the first component 1.

Still refer to FIG. 1. In an embodiment, on one side of the second pad 21, solder joints between the at least two wires 3 and the second pad 21 are also sequentially stacked, so that the at least two wires 3 are sequentially arranged in a direction perpendicular to a surface of the first pad 11. There is one solder joint between one wire 3 and the second pad 21, and the solder joints of the at least two wires 3 are stacked. Specifically, a solder joint between the first wire 33 and the second pad 21 and a solder joint between the second wire 34 and the second pad 21 are stacked. The solder joint between the wire 3 and the second pad 21 is not a solder joint generated by directly soldering the wire 3 to the second pad 21, but is a solder joint at one end that is of the wire 3 and at which the wire 3 is soldered to the second pad 21. A size of the second pad 21 may be designed to be small, and a density of the pad disposed on the second component 2 may be high. This helps increase a quantity of signals transmitted by the second component 2 and increase a density of a signal transmission wire of the second component 2.

FIG. 2 is a diagram of a structure of an electronic device according to an embodiment of this application. As shown in FIG. 2, an example in which the electronic device is an optical module is used. The optical module includes a digital signal processor, a trans-impedance amplifier, a photodetector, a driver, and a modulator. The photodetector, the trans-impedance amplifier, and the digital signal processor are sequentially connected, and the digital signal processor, the driver group, and the modulator are sequentially connected. The photodetector and the trans-impedance amplifier are respectively used as the first component and the second component, and are connected via a wire by using the foregoing solution. In addition, the driver group and the modulator may also be used as the first component and the second component, and are connected via a wire by using the foregoing solution. FIG. 3 is a diagram of comparison between eye patterns of electronic devices. As shown in FIG. 3, an eye pattern of an optical module in the conventional technology is shown in a left figure, and an eye pattern provided in embodiments of this application is shown in a right figure. It can be learned that the technical solutions of this application exhibits a significant improvement in the eye pattern.

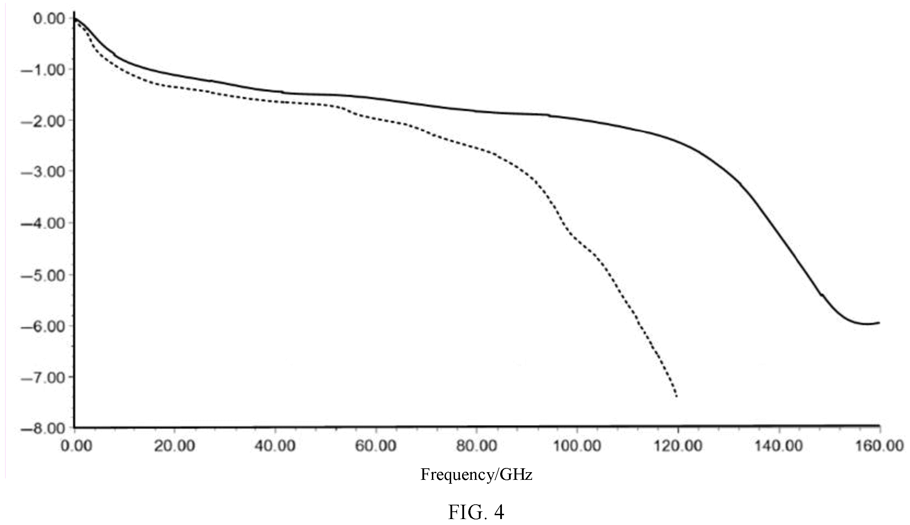

FIG. 4 is a diagram of comparison between working states of electronic assemblies. As shown in FIG. 4, a dashed line in the figure is a diagram of a working state of an electronic assembly in the conventional technology, and a solid line is a diagram of a working state of an electronic assembly in embodiments of this application. It can be learned that a cut-off frequency of the electronic assembly is increased from 80 GHz to 120 GHz, and an operating bandwidth of the electronic assembly is significantly improved.

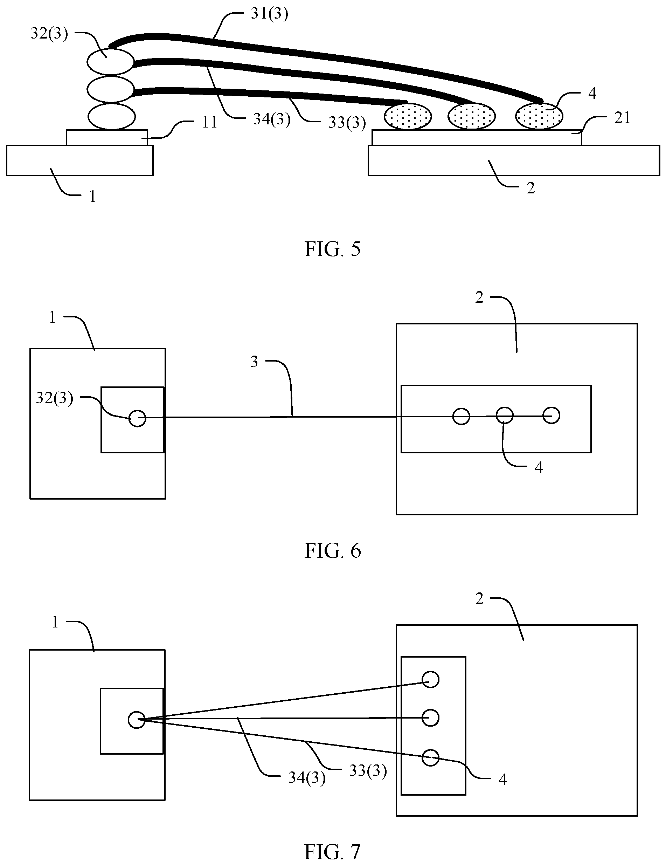

FIG. 5 is a diagram of a structure of an electronic assembly according to an embodiment of this application. FIG. 6 is a top view of a structure of an electronic assembly according to an embodiment of this application. As shown in FIG. 5 and FIG. 6, in an embodiment, on one side of the first pad 11, the solder joints between the at least two wires 3 and the first pad 11 are sequentially stacked; and on one side of the second pad 21, the solder joints between the at least two wires 3 and the second pad 21 are arranged in a row on the surface of the second pad 21. That is, the solder joint between the first wire 33 and the first pad 11 and the solder joint between the second wire 34 and the first pad 11 are stacked, and the solder joint between the first wire 33 and the second pad 21 and the solder joint between the second wire 34 and the second pad 21 are arranged side by side. In some application scenarios, if a size of the second pad 21 is large, this solution may also be used to simplify the wire bonding process of the first component 1 and the second component 2.

As shown in FIG. 6, in a specific embodiment, a direction in which the solder joints between the at least two wires 3 and the second pad 21 are arranged in a row on the surface of the second pad 21 is basically consistent with an extension direction of the wires 3. In other words, the direction in which the solder joints between the at least two wires 3 and the second pad 21 are arranged in a row on the surface of the second pad 21 is consistent with an arrangement direction of the first component 1 and the second component 2, so that the wires 3 are arranged in the direction perpendicular to the surface of the first pad 11.

FIG. 7 is a top view of a structure of an electronic assembly according to an embodiment of this application. As shown in FIG. 7, in another embodiment, there is a specific angle between the direction in which the solder joints between the at least two wires 3 and the second pad 21 are arranged in a row on the surface of the second pad 21 and the arrangement direction of the first component 1 and the second component 2. In a possible embodiment, the specific angle may be 90°. In some other embodiments, the specific angle may alternatively be 30°, 35°, 38°, 40°, 42°, 45°, 50°, 55°, 60°, 65°, 68°, 70°, 73°, 75°, 80°, 85°, or the like. In conclusion, wire bonding and connection may be performed based on an actual structure or layout of a product.

Refer to FIG. 1 and FIG. 5. The wire 3 in this application includes a wire body 31 and a solder ball 32, the solder ball 32 and the wire body 31 are of an integrated structure, and the solder ball 32 is located at one end of the wire body 31. Specifically, the wire body 31 may be formed by stretching a spherical metal ball, to form a metal wire. One end that is of the wire 3 and at which there is the solder ball 32 is a first bonding point, and the other end, that is, a wedge-shaped end, is a second bonding point. Specifically, the second bonding point is located at one end that is of the wire body 31 and that is away from the solder ball 32.

Refer to FIG. 1. In an embodiment, when the first pad 11 and the second pad 21 are connected by using the wires 3, in two adjacent wires 3, a first bonding point of one wire 3 is soldered to the first pad 11, and a second bonding point of the wire 3 is soldered to the second pad 21; and a second bonding point of the other wire 3 is soldered to the first pad 11, and a first bonding point of the other wire 3 is connected to the second pad 21. For example, a first bonding point of a first wire 33 is soldered to the first pad 11, and a second bonding point of the first wire 33 is soldered to the second pad 21; and a first bonding point of a second wire 34 is soldered to the first pad 11, and a second bonding point of the second wire 34 is soldered to the second pad 21. In this embodiment, on a same pad, first bonding points and second bonding points of a plurality of wires 3 are sequentially alternately stacked and soldered.

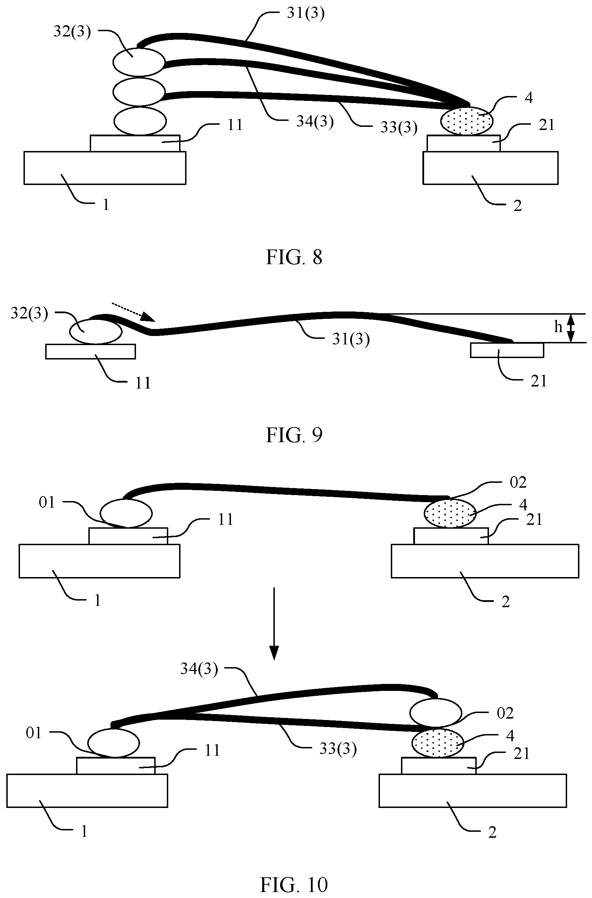

FIG. 8 is a diagram of a structure of an electronic assembly according to an embodiment of this application. As shown in FIG. 8, in an embodiment, in two adjacent wires, a first bonding point of one wire 3 is soldered to the first pad 11, and a second bonding point of the wire 3 is soldered to the second pad 21; and a first bonding point of the other wire 3 is also soldered to the first pad 11, and a second bonding point of the other wire 3 is soldered to the second pad 21. First bonding points of a plurality of wires are stacked on the first pad 11, and second bonding points of the plurality of wires 3 are soldered to the second pad 21.

Because a size of the second bonding point is small, when the second bonding point of the wire 3 is directly soldered to the first pad 11, there is a solder bump between the second bonding point of the wire 3 and the first pad 11. The second bonding point is soldered to the first pad 11 through the solder bump, thereby improving reliability of soldering the second bonding point to the first pad 11. Alternatively, the second bonding point of the wire 3 may alternatively be soldered to the first pad 11 through a solder ball 32 of an adjacent wire 3. In conclusion, there is a specific connection object between a second bonding point of any wire 3 and the first pad 11, and the second bonding point is not directly soldered to the first pad 11.

Similarly, when the second bonding point of the wire 3 is directly soldered to the second pad 21, there is a solder bump between the second bonding point of the wire 3 and the second pad 21. The second bonding point is soldered to the second pad 21 through the solder bump, thereby improving reliability of soldering the second bonding point to the second pad 21. Alternatively, the second bonding point of the wire 3 may alternatively be soldered to the second pad 21 through a solder ball 32 of an adjacent wire 3. In conclusion, there is a specific connection object between a second bonding point of any wire 3 and the second pad 21, and the second bonding point is not directly soldered to the first pad 11.

FIG. 9 is a diagram of a structure of a wire according to an embodiment of this application. As shown in FIG. 9, in an embodiment, the solder ball 32 of the wire 3 is soldered to the first pad 11, and the wire body 31 is tilted toward the first pad 11 within a preset length on a side that is of the wire body 31 and that is connected to the solder ball 32. Specifically, when the wire 3 is formed, a solder head of a wire bonder moves in a plurality of steps to form the tilted structure of the wire body 31, so that the wire 3 is relatively flat above the solder ball 32. This facilitates soldering and stacking another wire 3 above a first bonding point of the wire 3, and prevents the wire 3 from being tilted. In this way, reliability of soldering between adjacent wires 3 is improved, and it is less likely to cause short circuits during wire stacking.

Still refer to FIG. 9. In a specific embodiment, an arc height h of the wire body 31 of the wire 3 is less than or equal to 50 µm. In this solution, the wire 3 has a low arc height and small parasitic inductance. This solution also helps improve an operating bandwidth of the electronic assembly, improve a signal transmission rate of the electronic assembly, and the like. In this way, the electronic assembly has good performance. In addition, in this solution, the wire 3 is also relatively flat near the second bonding point. This facilitates soldering and stacking another wire 3 above the second bonding point of the wire 3, and prevents the wire 3 from being tilted. In this way, reliability of soldering between adjacent wires 3 is improved, and it is less likely to cause short circuits during wire stacking.

Based on a same inventive idea, this application further provides a preparation method for an electronic assembly. The electronic assembly prepared by using the method includes the first component 1, the second component 2, the first wire 33, and the second wire 34, the first component 1 includes the first pad 11, and the second component 2 includes the second pad 21. Specifically, the electronic assembly prepared by using the preparation method is the electronic assembly shown in the foregoing embodiments. FIG. 10 is a diagram of a preparation procedure of an electronic assembly according to an embodiment of this application. As shown in FIG. 10, the foregoing preparation method specifically includes the following steps:
soldering one end of the first wire 33 to the first pad 11 to form a first solder joint 01, and soldering the other end of the first wire 33 to the second pad 21 to form a second solder joint 02;
soldering one end of the second wire 34 to the first solder joint 01, and soldering the other end of the second wire 34 to the second solder joint 02; and
connecting the first wire 33 and the second wire 34 in parallel.

In the electronic assembly prepared by using this solution, the two wires 3 are connected in parallel, to reduce parasitic inductance caused by the wires 3, improve an operating bandwidth of the electronic assembly, improve a signal transmission rate of the electronic assembly, and the like. In this way, the electronic assembly has good performance. In this solution, a diameter of the wire 3 may be designed to be small, thereby reducing a risk of damage to the first pad 11. Further, solder joints of the two wires 3 are sequentially stacked on the first pad 11, and solder joints of the two wires 3 are sequentially stacked on the second pad 21. A size of the first pad 11 and a size of the second pad 21 may be designed to be small. This helps increase a density of the pad of the first component 1 and a density of the pad of the second component 2, increase a quantity of signals transmitted by the first component 1 and a quantity of signals transmitted by the second component 2, and increase a density of a signal transmission wire of the first component 1 and a density of a signal transmission wire of the second component 2.

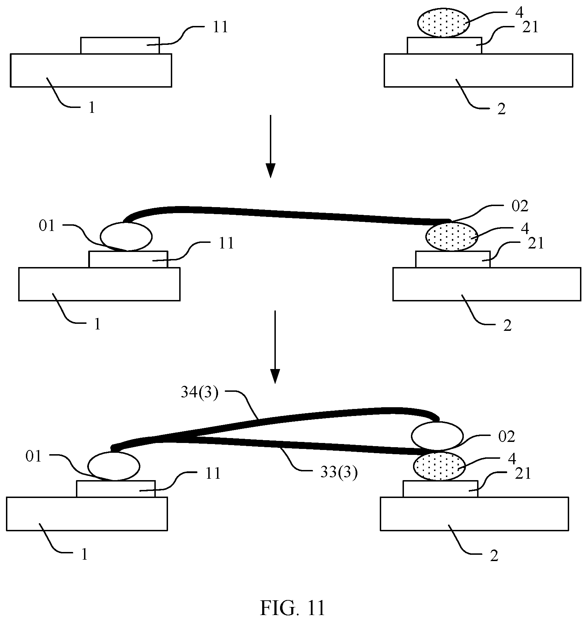

In an embodiment, the wire 3 includes the wire body 31 and a ball, a solder ball 32 of the first wire 33 is soldered to the first pad 11, and one end that is of the wire body 31 and that is away from the solder ball 32 is soldered to the second pad 21. FIG. 11 is a diagram of a preparation procedure of an electronic assembly according to an embodiment of this application. As shown in FIG. 11, one end of the first wire 33 is soldered to the first pad 11 to form a first solder joint 01, and the other end of the first wire 33 is soldered to the second pad 21 to form a second solder joint 02. Before that, the method further includes:
soldering a solder bump to the second pad 21.

That the end of the first wire 33 is soldered to the first pad 11 to form the first solder joint 01, and the other end of the first wire 33 is soldered to the second pad 21 to form the second solder joint 02 specifically includes: soldering one end that is of the first wire 33 and at which there is the solder ball 32 to the first pad 11 to form the first solder joint 01, and soldering one end that is of the wire body 31 of the first wire 33 and that is away from the solder ball 32 to the solder bump of the second pad 21 to form the second solder joint 02, to improve reliability of soldering the wire body 31 to the second pad 21.

In another embodiment, the wire 3 includes the wire body 31 and a ball, a solder ball 32 of the first wire 33 is soldered to the second pad 21, and one end that is of the wire body 31 and that is away from the solder ball 32 is soldered to the first pad 11. Similarly, one end of the first wire 33 is soldered to the first pad 11 to form a first solder joint 01, and the other end of the first wire 33 is soldered to the second pad 21 to form a second solder joint 02. Before that, the method further includes:
soldering a solder bump to the first pad 11.

That the end of the first wire 33 is soldered to the first pad 11 to form the first solder joint 01, and the other end of the first wire 33 is soldered to the second pad 21 to form the second solder joint 02 specifically includes: soldering the end that is of the wire body 31 of the first wire 33 and that is away from the solder ball 32 to the solder bump of the first pad 11 to form the first solder joint 01, and soldering one end that is of the first wire 33 and at which there is the solder ball 32 to the second pad 21 to form the second solder joint 02, to improve reliability of soldering the wire body 31 to the first pad 11.

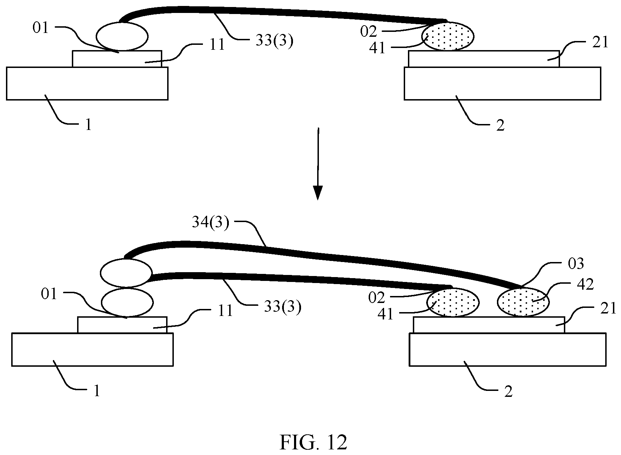

Based on a same inventive idea, this application further provides a preparation method for an electronic assembly. The electronic assembly prepared by using the method includes the first component 1, the second component 2, the first wire 33, and the second wire 34, the first component 1 includes the first pad 11, and the second component 2 includes the second pad 21. Specifically, the electronic assembly prepared by using the preparation method is the electronic assembly shown in the foregoing embodiments. FIG. 12 is a diagram of a preparation procedure of an electronic assembly according to an embodiment of this application. As shown in FIG. 12, the preparation method specifically includes the following steps:
soldering one end of the first wire 33 to the first pad 11 to form a first solder joint 01, and soldering the other end of the first wire 33 to the second pad 21 to form a second solder joint 02;
soldering one end of the second wire 34 to the first solder joint 01, and soldering the other end of the second wire 34 to the second pad 21 to form a third solder joint 03, where the second solder joint 02 and the third solder joint 03 are arranged side by side on a surface of the second pad 21; and
connecting the first wire 33 and the second wire 34 in parallel.

Specifically, the second solder joint 02 and the third solder joint 03 are disposed side by side. In some application scenarios, if a size of the second pad 21 is large, this solution may also be used to simplify a wire 3 bonding process of the first component 1 and the second component 2.

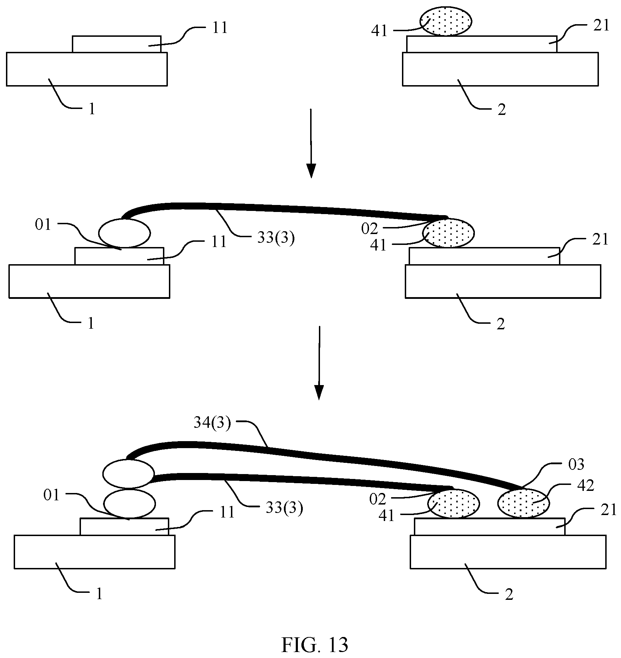

In an embodiment, the wire 3 includes the wire body 31 and a ball, a solder ball 32 of the first wire 33 is soldered to the first pad 11, and one end that is of the wire body 31 and that is away from the solder ball 32 is soldered to the second pad 21. FIG. 13 is a diagram of a preparation procedure of an electronic assembly according to an embodiment of this application. As shown in FIG. 13, one end of the first wire 33 is soldered to the first pad 11 to form a first solder joint 01, and the other end of the first wire 33 is soldered to the second pad 21 to form a second solder joint 02. Before that, the method further includes:
soldering a first solder bump 41 and a second solder bump 42 to the second pad 21, where the first solder bump 41 and the second solder bump 42 are disposed side by side.

That the end of the first wire 33 is soldered to the first pad 11 to form the first solder joint 01, and the other end of the first wire 33 is soldered to the second pad 21 to form the second solder joint 02 specifically includes: soldering one end that is of the first wire 33 and at which there is the solder ball 32 to the first pad 11 to form the first solder joint 01, and soldering one end that is of the wire body 31 of the first wire 33 and that is away from the solder ball 32 to the first solder bump 41 of the second pad 21 to form the second solder joint 02, to improve reliability of soldering the wire body 31 to the second pad 21.

That one end of the second wire 34 is soldered to the first solder joint 01, and the other end of the second wire 34 is soldered to the second pad 21 to form the third solder joint 03 specifically includes: soldering the end of the second wire 34 to the first solder joint 01, and soldering the other end of the second wire 34 to the second solder bump 42 of the second pad 21 to form the third solder joint 03.

In another embodiment, the wire 3 includes the wire body 31 and a ball, a solder ball 32 of the first wire 33 is soldered to the second pad 21, and one end that is of the wire body 31 and that is away from the solder ball 32 is soldered to the first pad 11. Similarly, one end of the first wire 33 is soldered to the first pad 11 to form a first solder joint 01, and the other end of the first wire 33 is soldered to the second pad 21 to form a second solder joint 02. Before that, the method further includes:
soldering a third solder bump to the first pad 11.

That the end of the first wire 33 is soldered to the first pad 11 to form the first solder joint 01, and the other end of the first wire 33 is soldered to the second pad 21 to form the second solder joint 02 specifically includes: soldering the end that is of the wire body 31 of the first wire 33 and that is away from the solder ball 32 to the solder bump of the first pad 11 to form the first solder joint 01, and soldering one end that is of the first wire 33 and at which there is the solder ball 32 to the second pad 21 to form the second solder joint 02, to improve reliability of soldering the wire body 31 to the first pad 11.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic assembly, comprising a first component, a second component, and at least two wires, wherein the first component comprises a first pad, the second component comprises a second pad, and the at least two wires comprise a first wire and a second wire;
the first wire is soldered between the first pad and the second pad, the second wire is also soldered between the first pad and the second pad, and the first wire and the second wire are connected in parallel; and
a solder joint between the first wire and the first pad and a solder joint between the second wire and the first pad are stacked.

2. The electronic assembly according to claim 1, wherein a solder joint between the first wire and the second pad and a solder joint between the second wire and the second pad are stacked.

3. The electronic assembly according to claim 1, wherein a solder joint between the first wire and the second pad and a solder joint between the second wire and the second pad are arranged side by side on a surface of the second pad.

4. The electronic assembly according to any one of claims 1 to 3, wherein the wire comprises a wire body and a solder ball, the solder ball and the wire body are of an integrated structure, the solder ball is located at one end of the wire body, one end that is of the wire and at which there is the solder ball is a first bonding point, and the other end of the wire is a second bonding point.

5. The electronic assembly according to claim 4, wherein the first bonding point of the first wire is soldered to the first pad, and the first bonding point of the second wire is soldered to the first pad.

6. The electronic assembly according to claim 4, wherein the first bonding point of the first wire is soldered to the first pad, and the second bonding point of the second wire is soldered to the first pad.

7. The electronic assembly according to any one of claims 4 to 6, wherein when the second bonding point is directly soldered to the first pad, there is a solder bump between the second bonding point and the first pad; and when the second bonding point is directly soldered to the second pad, there is a solder bump between the second bonding point and the second pad.

8. The electronic assembly according to any one of claims 4 to 7, wherein the wire body is tilted toward the first pad within a preset length on a side that is of the wire body and that is connected to the solder ball.

9. The electronic assembly according to any one of claims 4 to 8, wherein an arc height of the wire body is less than or equal to 50 µm.

10. The electronic assembly according to any one of claims 1 to 9, wherein
the first component is a photodetector, and the second component is a trans-impedance amplifier;
the first component is a driver, and the second component is a modulator;
the first component is a trans-impedance amplifier, and the second component is an electrical chip; or
the first component is an optical chip, and the second component is a substrate.

11. An electronic device, comprising a circuit board, an electronic component, and the electronic assembly according to any one of claims 1 to 10, wherein the electronic component is electrically connected to the electronic assembly, and the electronic component and the electronic assembly are disposed on the circuit board.

12. A preparation method for an electronic assembly, wherein the electronic assembly comprises a first component, a second component, a first wire, and a second wire, the first component comprises a first pad, and the second component comprises a second pad; and the preparation method comprises:
soldering one end of the first wire to the first pad to form a first solder joint, and soldering the other end of the first wire to the second pad to form a second solder joint;
soldering one end of the second wire to the first solder joint, and soldering the other end of the second wire to the second solder joint; and
connecting the first wire and the second wire in parallel.

13. A preparation method for an electronic assembly, wherein the electronic assembly comprises a first component, a second component, a first wire, and a second wire, the first component comprises a first pad, and the second component comprises a second pad; and the preparation method comprises:
soldering one end of the first wire to the first pad to form a first solder joint, and soldering the other end of the first wire to the second pad to form a second solder joint;
soldering one end of the second wire to the first solder joint, and soldering the other end of the second wire to the second pad to form a third solder joint, wherein the second solder joint and the third solder joint are arranged side by side on a surface of the second pad; and
connecting the first wire and the second wire in parallel.
